(19) Europäisches Patentamt / European Patent Office / Office européen des brevets

(11) **EP 4 246 558 B1**

(12) **EUROPEAN PATENT SPECIFICATION**

(45) Date of publication and mention
of the grant of the patent:
**05.06.2024 Bulletin 2024/23**

(21) Application number: **22716119.7**

(22) Date of filing: **14.02.2022**

(51) International Patent Classification (IPC):
**H01L 21/425** (2006.01) **H01L 21/34** (2006.01)
**C30B 33/06** (2006.01)

(52) Cooperative Patent Classification (CPC):
**H01L 21/425; C30B 29/16; C30B 29/60;**
**C30B 33/06; H01L 21/02002; H01L 21/34**

(86) International application number:
**PCT/PT2022/050006**

(87) International publication number:
**WO 2022/173319 (18.08.2022 Gazette 2022/33)**

(54) **PROCESS FOR PRODUCING ROLLS AND MEMBRANES OF SUBMICROMETRIC THICKNESS OF GA2O3 BY ION IMPLANTATION**

VERFAHREN ZUR HERSTELLUNG VON ROLLEN UND MEMBRANEN MIT SUBMIKROMETRISCHER GA2O3-DICKE DURCH IONENIMPLANTATION

PROCÉDÉ DE PRODUCTION DE ROULEAU ET DE MEMBRANE SOUS-MICROMÉTRIQUE DE GA2O3 PAR IMPLANTATION IONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.02.2021 PT 2021117063**

(43) Date of publication of application:
**20.09.2023 Bulletin 2023/38**

(73) Proprietor: **Instituto Superior Técnico
1049-001 Lisboa (PT)**

(72) Inventors:
• **LORENZ, Katharina**
**1800-241 Lisboa (PT)**
• **ANTÓNIO BAPTISTA PERES, Marco**
**1750 Lisboa (PT)**
• **JORGE DA COSTA ALVES, Eduardo**
**1500-230 Lisboa (PT)**
• **MANUEL VARELAS DA ROCHA, Jorge**
**2765-560 Lisboa (PT)**

(74) Representative: **RCF - Protecting Innovation, S.A.
Rua Tomás Ribeiro, nº 45-2º
1050-225 Lisboa (PT)**

(56) References cited:
• **ZHE CHENG ET AL: "Wafer-scale Heterogeneous Integration of Monocrystalline beta-Ga2O3 Thin Films on SiC for Thermal Management by Ion-Cutting Technique", ARXIV.ORG, CORNELL UNIVERSITY LIBRARY, 201 OLIN LIBRARY CORNELL UNIVERSITY ITHACA, NY 14853, 27 May 2020 (2020-05-27), XP081684126,**
• **KIM MUNHO ET AL: "Recent advances in free-standing single crystalline wide band-gap semiconductors and their applications: GaN, SiC, ZnO, [beta]-Ga 2 O 3 , and diamond", JOURNAL OF MATERIALS CHEMISTRY C, vol. 5, no. 33, 1 January 2017 (2017-01-01), pages 8338-8354, XP055932730, GB ISSN: 2050-7526, DOI: 10.1039/C7TC02221B**

**(Cont. next page)**

• Liao Michael E ET AL: "Exfoliation of [beta]-Ga 2 O 3 Along a Non-Cleavage Plane Using Helium Ion Implantation Exfoliation of [beta]-Ga 2 O 3 Along a Non-Cleavage Plane Using Helium Ion Implantation", ECS Journal of Solid State Science and Technology ECS J. Solid State Sci. Technol. ECS Journal of Solid State Science and Technology, 1 January 2019 (2019-01-01), pages 673-676, XP055932834, Retrieved from the Internet: URL:https://iopscience.iop.org/article/10. 1149/2.0051911jss/pdf?casa_token=sfHWenAqt ncAAAAA:QTfp_Rdej-Sjz8ABJLnGzoy4saYUsef CWx J092Qg-LSX3KSGpuL2pp1wVd3OBZ3w-5T9Gis YdgY [retrieved on 2022-06-18] cited in the application

**Description**

**FIELD OF THE INVENTION**

The present invention relates to a process for producing a roll with submicrometer thick wall and a membrane of submicrometric thickness of $Ga_2O_3$ by ion implantation of a semiconductor monocrystal of $Ga_2O_3$ using ion beams, at specific conditions of energy, flux and fluence and subsequent thermal treatment. The process of the invention finds application, for example, in the field of microelectronics, micro-electromechanics and photonics.

**BACKGROUND OF THE INVENTION**

The process of producing rolls and membranes of submicrometric thickness (10-1000 nm thick) from monocrystalline materials has been extensively studied and developed in recent years due to their technological potential in different applications: electronic, optical and mechanical (Mikayla A. Yoder et al., J. Am. Chem. Soc., 140, 9001-9019 (2018) and Minghuang Huang et al., Nanoscale, 3, 96 (2011)).

Patent application US6008126A refers to a general method for producing integrated circuits and interconnected metallization structures from membranes of dielectric and semiconductor materials. This patent application is an unmistakable example of the potential and growing technological interest in membranes of submicrometric thickness of different materials, insulators, semiconductors and conductors.

Mechanical exfoliation is one of the most used processes to obtain membranes of submicrometric thickness and has become extremely popular, namely in obtaining graphene using conventional adhesive tape. This process does not require any pre-treatment or sacrificial layer; however, it has the disadvantage of not having any control over the thickness and area of the layer obtained. In spite of its simplicity, the fact that this process does not allow, in most cases, to control the thickness or the area of the layer obtained, limits its industrial use on a large scale, since for large-scale production, well-controlled and reproducible processes are required.

A relevant example of the production of monocrystalline material membranes with thickness control is the use of silicon in the development of semiconductor-oxide-semiconductor structures (known as "silicon on insulator - SOI"). This method is reported in patent application US5882987A. In this case, ion implantation is performed using a beam of hydrogen ions (M. Bruel, B. Aspar, and A.-J. Auberton-Hervé, Jpn. J. Appl. Phys., 36, 1636 (1997)) or helium (C. Qian and B. Terreault, J. Appl. Phys., 90, 5152 (2001)) to create a layer with microbubbles of hydrogen or helium at a specific depth determined by the energy of the implanted ions. The formation of these microbubbles induces stress that allows the separation of a thin layer from the surface of the implanted material when the implanted materials are subjected to an adequate thermal treatment. From this method, it is possible to transfer large areas of thin silicon layers to other types of substrates. This method has been explored in other semiconductors such as II-VI semiconductors (C. Miclaus, G. Malouf, SM Johnson, and MS Goorsky, J. Electron. Mat., 34(6),859 (2005)), III-V seminconductor (S. Hayashi, D. Bruno, and MS Goorsky, Appl. Phys. Lett., 85, 236 (2004)) and germanium (C. Miclaus and MS Goorsky, J. Phys. D: Appl. Phys., 36, A177 (2003)) and more recently in Oxide semiconductors (Michael E. Liao et al, ECS J. Solid State Sci. Technol. 8 P673 (2019)).

In the work of Minghuang et al., 2011, 3, 96, different examples are described for the production of rolls by creating strain between the layer that composes the rolls and their physical support (substrate or sacrificial layer). The main examples are: layers deposited on a substrate with different lattice constants (heteroepitaxial deposition); layers deposited on a substrate or another layer (sacrificial layer) without any epitaxial relationship (non-epitaxial deposition); bi-layers of materials with different thermal expansions. In all these examples, the thin layer obtained and which composes the roll, results from a physical or chemical deposition process. For this reason, their electrical, optical, structural and mechanical properties are strongly conditioned by the fact that they result from a heteroepitaxial or non-epitaxial deposition process.

The US8313966 B2 patent reports a process for producing rolls of different materials for the development of optoelectronic applications. In this particular patent for the formation of Rolls it is necessary to deposit a sacrificial layer on a substrate on which at least one additional layer of material will be deposited, that will self-roll as the sacrificial layer is removed by a chemical etching process. The self-rolling process that occurs with the etching of the sacrificial layer is associated with the relaxation of strain between the sacrificial layer and the surface layer (layer that rolls up producing the rolls) as is also described by Schmidt et al., Physica E 13 969 (2002). ZHE CHENG ET AL: "Wafer-scale Heterogeneous Integration of Monocrystalline beta-Ga2O3 Thin Films on SiC for Thermal Management by Ion-Cutting Technique", ARXIV.ORG, CORNELL UNIVERSITY LIBRARY, 201 OLIN LIBRARY CORNELL UNIVERSITY ITHACA, NY 14853, 27 May 2020 (2020-05-27), XP081684126 discloses a process of production of a membrane of submicrometric thickness.

There is a need to provide alternative membrane of submicrometric thickness and roll production processes from a semiconductor monocrystal that eliminate bubble production, the need of a sacrificial layer and the limitation to the use of gas ion beams.

## SUMMARY OF THE INVENTION

The present invention provides a process for producing membrane of submicrometric thickness of $Ga_2O_3$ and roll comprising the steps of:

a) implanting ions in a semiconductor monocrystal of $Ga_2O_3$, with a cleavage plane parallel to the surface, at a temperature below 500 °C, making the ion beam to strike the monocrystal along a non-parallel direction to the referred cleavage plane, with an energy in the range of 10-4000 keV, a flux in the range of $1\times10^{12}$-$1\times10^{14}$ ions/cm$^2$.s and a fluence in the range of $1\times10^{13}$-1x10$^{16}$ ions/cm$^2$, with a formation of at least one roll;

b) subjecting the, at least one, roll formed in step a) to a thermal treatment at a temperature equal to or higher than 500°C.

In a preferred embodiment, the process repeats, in order, steps a) and b).

In a further preferred embodiment, the process further comprises an intermediate step between steps a) and b), wherein the at least one formed roll is transferred to a temperature stable substrate and then heated to the temperature of the thermal treatment of step b). Preferably, the substrate is silicon.

In another preferred embodiment, the process comprises a step prior to step a), wherein at least one additional conductive, semiconducting or insulating layer is deposited on the single crystal of $Ga_2O_3$.

In one aspect of the invention, the ion beam is selected from the group comprising Chromium (Cr), Iron (Fe), Nitrogen (N), Carbon (C) and Tungsten (W) ions.

In a preferred embodiment, the heat treatment of step b) is done at an annealing temperature of 700°C during 30 seconds.

In one embodiment, the ion beam during implantation is in a stationary mode.

In another embodiment, the ion beam during implantation is in a sweeping mode.

## BRIEF DESCRIPTION OF THE FIGURES

Figure 1. Scanning electron microscopy image obtained for rolls of $Ga_2O_3$ with a submicrometric thickness wall produced in accordance with the present invention, using a Chromium ion beam with an energy of 180keV, with a flux of 2.083 ions/cm$^2$.s and a total fluence of 1x10$^{15}$ ions/cm$^2$.

Figure 2. Optical microscopy image obtained for a membrane of submicrometric thickness of $Ga_2O_3$ obtained after a thermal treatment at 700°C, during 30 seconds, of a roll as shown in Figure 1, according to the process of the present invention.

Figure 3. Schematic of the production process of the present invention in stationary mode: A) virgin single crystal (1) used for implantation; B) single crystal (1) and implanted layer (3) with a specific ion (2); C) single crystal (1), implanted layer (3), beginning of bending near the ends of the single crystal (3'); D) formation of the rolls (4) due to the self-rolling of the exfoliated surface layer.

Figure 4. Schematic of the production process of the present invention in scanning mode: A) single crystal (1) and implanted region or layer (3), with a specific ion (2) (the dashed line indicates the beam path (5) ); B) and C) roll (4') induced by implantation; D) final roll (4).

## DETAILED DESCRIPTION OF THE INVENTION

The present invention reports a process for producing a membrane of submicrometric thickness and roll of $Ga_2O_3$ by ion implantation of a single semiconductor crystal of $Ga_2O_3$ in the beta phase, at specific conditions of energy, flux and fluence and subsequent thermal treatment.

In the context of the present description, the term "comprising" is to be understood as "including but not limited to". As such, this term should not be interpreted as "consisting only of".

Any X value presented along the present description should be interpreted as an approximate value of the real X value, such approximation to the true value would be reasonably expected by the expert person responsible for the implantation due to experimental and/or measurement conditions that introduce deviations from the real value.

Unless otherwise indicated, the ranges of values presented in the present description are intended to provide a simplified and technically accepted way to indicate each individual value within the respective range. By way of example, the expression "1 to 2" or "between 1 and 2" means any value within this range, for example 1.0; 1.1; 1.2; 1.3; 1.4; 1.5; 1.6; 1.7; 1.8; 1.9; 2.0.

In the context of the present invention, the term "membrane" refers to a material with a submicrometric thickness (10-1000 nm).

In the context of the present invention "thermal treatment" refers to any technical process that applies a temperature equal to or greater than 500 °C on the roll or rolls obtained by the process of the invention.

Still in the context of the present invention, ambient temperature corresponds to a temperature in the range between 15°C and 25°C.

The process of the present invention comprises the steps of:

a) implanting ions in a semiconductor monocrystal of $Ga_2O_3$, with a cleavage plane parallel to the surface, at a temperature below 500 °C, making an ion beam strike along a non-parallel direction to the referred cleavage plane, with an energy in the range of 10-4000 keV, a flux in the range of $1\times10^{12}$-$1\times10^{14}$ ions/cm2.s and a fluence in the range of $1\times10^{13}$-$1\times10^{16}$ ions/cm$^2$, with formation of at least one roll;

b) subjecting the, at least one, roll formed in step a) to a thermal treatment at a temperature equal to or greater than 500°C.

Ion implantation is a common technique in the microfabrication industry of silicon-based integrated circuits and serves to incorporate ions of different chemical elements in a matrix material with a well-defined profile. During studies on the potential of the intrinsic properties of chromium ions for the development of optical detectors of ionizing radiation in the red region, by ion implantation of chromium ions in gallium oxide ($Ga_2O_3$), surprisingly, the formation of rolls on the surface of a $Ga_2O_3$ monocrystal was observed (for implantations performed with low flux, below $2.083\times10^{12}$ ions/cm$^2$).

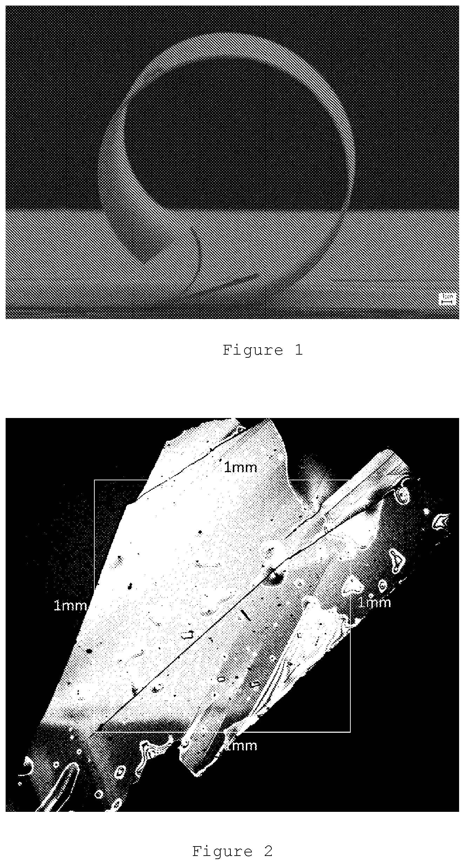

During the implantation step of the present invention, ions are accelerated by an applied electric field acquiring a kinetic energy directly proportional to this. The penetration depth of the ions implanted in the single crystal of $Ga_2O_3$ depends on its intrinsic properties, namely on its composition and density, but also on the energy of the ion implanted in the studied matrix. In addition, the single crystal of $Ga_2O_3$ presents an easy cleavage plane parallel to the surface (100), whereby implantation-induced bending under certain specific energy, fluence and flux conditions unexpectedly creates a breakdown of chemical bonds along the cleavage plane at a certain depth, thus initiating the delamination of a layer of submicrometric thickness, defined between the surface and the plane in which the chemical bonds break, promoting the formation of rolls (Figure 1).

$Ga_2O_3$ in the beta phase $\beta$-$Ga_2O_3$) is a crystal with a monoclinic crystal structure in which its unit cell is defined by three crystalline axes a, b and c with different lattice parameters 12.03, 3.04 and 5.80 Angstrom, respectively (1 Angstrom corresponds to $10^{-10}$ m). The angular relationship between a and b and between b and c are 90° and the angular relationship between a and c is 103.7°. The crystalline directions parallel to the crystalline axes a, b and c, applying the nomenclature used in crystallography, are defined as [100], [010] and [001] respectively. The crystal has two easy cleavage planes, the (100) plane and the (001) plane, being the easiest cleavage plane the plane (100).

It was also found that this unexpected effect during implantation in the semiconductor monocrystal of $Ga_2O_3$ also occurs when using ions other than Chromium, such as Iron, Nitrogen, Carbon and Tungsten. It was also found that this effect does not dependent on the charge of the implanted ions.

Furthermore, it was also found that the application of a thermal treatment at a temperature equal to or higher than 500°C promotes the unrolling of the rolls, removing the defects created in the implantation step. It is thus possible to obtain a membrane of submicrometric thickness of $Ga_3O_3$ with a thickness that is closely related to the implantation energy and penetration depth of the implanted ion (Figure 2).

The process of this invention eliminates the need for bubble formation and the limitation to implantation with gas ion beams, as well as the need of a sacrificial layer for the formation of the membrane of submicrometric thickness of $Ga_2O_3$ and, therefore, does not present the disadvantages associated with those processes enumerated above.

In one embodiment, the process comprises repeating steps a) and b).

In another embodiment of the invention, the process may comprise an intermediate step between steps a) and b) in which the at least one roll obtained is transferred to a substrate stable at the temperature of the thermal treatment of step b). Preferably, the substrate is silicon.

In another embodiment of the invention, the process may comprise a step prior to step a), in which at least one additional conductive, semiconducting or insulating layer is deposited on the single crystal of $Ga_2O_3$. Preferably, this layer is a metal or a sequence of layers of different metals that form electrical contacts of an electrical device. Preferably, this layer is a semiconductor or semiconductor structure that forms a semiconductor device on top of the roll or membrane.

The ion beam used in ion implantation step a) may be selected from the group comprising Chromium (Cr), Iron (Fe), Nitrogen (N), Carbon (C) and Tungsten (W) ions. Preferably, the ion beam consists of Chromium ions.

The parameters of step a) of ion implantation, i. e., energy, fluence and flux, are defined as a function of the type of single crystal to be implanted and the chosen ion beam. In particular, the person expert in ion implantation will understand that the ranges described herein for these parameters may be higher or lower depending on the type of single crystal to be implanted and the ion beam chosen. Thus, the person expert in ion implantation will understand that, for example, choosing ions other than those specifically mentioned herein requires adjusting the values of these parameters, the described ranges only serve as a reference values for those other ions.

Also, in case the process comprises the previous step of deposition of a metallic or semiconducting layer described above, the implantation parameters will have to be adjusted considering the energy loss of the ion beam in this layer, as well as the necessary change in the fluence so to change the concentration and profile of defects and thus control the stress profile for the delamination process to occur. The person expert in ion implantation will easily understand the adaptation of parameters as a function of the composition and thickness of the additional layer.

The ions can have any charge state, the parameters of step a) of ion implantation being defined and adjusted by the person expert in ion implantation. In the range of energies comprised by the present invention, the interaction that causes the crystal structure to change is the nuclear interaction (elastic collision) between the implanted ions and the nuclei of the atoms that compose the target material. This interaction is essentially independent of the initial charge state of the ion and the charge state choice will depend on the technical implementation of the ion sources and the implanter as well as the intended ion energy.

The implantation area can be defined by a hard mask or a deposited polymeric mask on the semiconductor monocrystal of $Ga_2O_3$. The fact that implantation regions can be defined makes it possible to develop roll patterns on the surface of the single crystal when complemented with physical and chemical patterning and etching techniques.

The implantation of the ion beam is performed at a temperature below 500 °C, by making an ion beam strike the surface of a $Ga_2O_3$ semiconductor monocrystal along a non-parallel direction to the cleavage plane. In one embodiment, implantation takes place at room temperature. In another embodiment, implantation is performed along the direction normal to the surface. Preferably, the implantation is performed in a direction perpendicular to the cleavage plane of the single crystal, i.e., the implantation is performed near the direction [201] which is the direction perpendicular to the cleavage plane of the single crystal (100).

Fluence is the number of ions implanted per sample area and is given by the flux (number of ions per second reaching a given area of the crystal) times the time (duration of the implantation process):

$$\texttt{Fluence(ions/cm}^2\texttt{)} = \texttt{flux (ions/cm}^2\texttt{.s)*time(s)}$$

Therefore, fluence, flux and implantation time are correlated. For example, a sample implanted with a flux of $10^{12}$ ions/$cm^2$.s for 100s receives a total fluence of 100s x $10^{12}$ ions/$cm^2$. s = $10^{14}$ ions/$cm^2$.

The implantation step of the process of the invention can be in stationary mode or scanning mode.

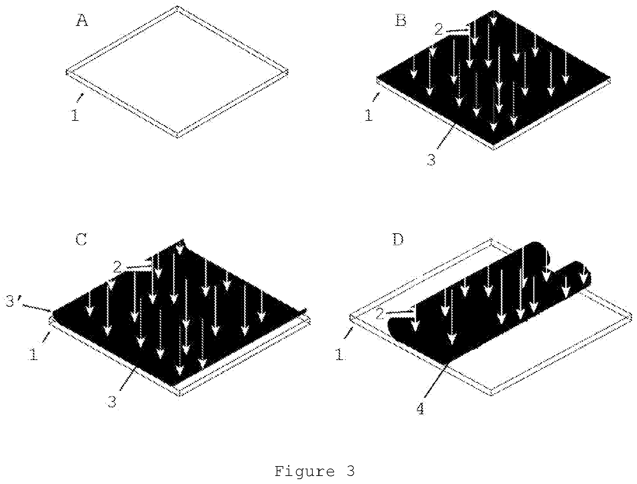

The steady-state implantation process is shown in Figure 3, in which a wide ion beam is used.

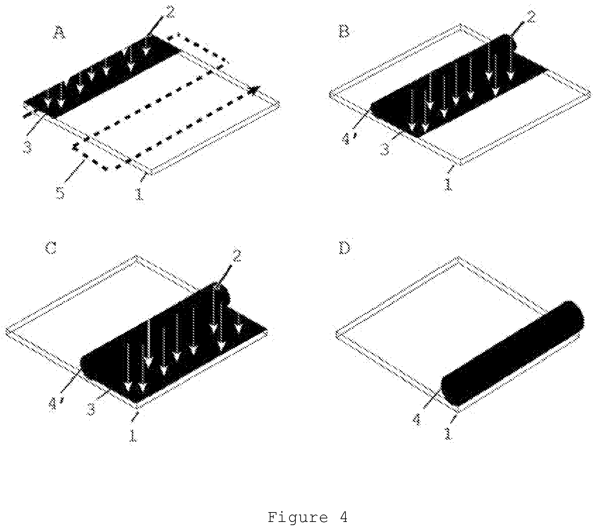

The implantation process in sweeping mode is represented in Figure 4, in which a spot beam with reduced cross-sectional area is used. In this mode, the implantation path is defined as a function of the beam cross-section in order to cover the entire area to be implanted.

The implantation cycle can be followed by a thermal treatment cycle so that the deformation induced during the roll formation can be reversed in the defined area. The process can then be repeated in different successive areas in order to increase the overall size of the membrane.

The great advantage and innovative character of the present invention is the fact that rolls can be directly obtained by self- rolling (4, 4') from a mono-crystalline material (1), thus guaranteeing their crystalline quality without the need of any additional deposition or sacrificial layers. Furthermore, in the case of the present invention, the self-rolling process that gives rise to the rolls (4, 4') can be reversed by carrying out a thermal treatment.

The thermal treatment of step b) of the process can be performed by any suitable technique. The temperature at which the thermal treatment takes place must be adequate to remove the defects created in the membrane during implantation as well as during the rolling during the implantation step and, thus, promoting the total unrolling of the same. For the present invention, the thermal treatment must be performed at a temperature equal to or greater than 500°C. The duration of the thermal treatment will depend on the type of treatment selected and performed at greater or lesser speed in order to achieve full membrane unroll.

Preferably, the thermal treatment can be by radiation, convection or thermal diffusion and can be performed in air or in a controlled atmosphere. In a more preferably mode, thermal treatment means thermal annealing, at a temperature of 700°C for 30 seconds.

**EXAMPLES**

**Example 1** - Production of roll and membrane of submicrometric thickness of $Ga_2O_3$ with implantation of chromium ions (Cr)

For the production of a membrane of submicrometric thickness of $Ga_2O_3$, a bulk monocrystal (with a thickness of several hundred micrometers) of $\beta$-$Ga_2O_3$ was used, having the surface plane (100) perpendicular to the [201] direction and it was implanted at room temperature with an angle of incidence normal to the surface, with a beam of $Cr^+$ and $Cr^{2+}$ ions with energy in the range of 100-360 keV, flux in the range of $1x10^{12}$ ions/$cm^2$. s-$2x10^{12}$ ions/$cm^2$.s and a fluence of $1x10^{15}$ ions/$cm^2$. The formation of rolls on the surface of the monocrystalline material of $\beta$-$Ga_2O_3$ was observed with walls of submicrometric thickness and diameters of a few tens of micrometers.

Then, the previously formed rolls were transferred to a silicon substrate and annealed by a thermal annealing process with a holding time of 30 seconds at 700 °C and with a heating rate of 1 °C per second. The thermal treatment promotes the unrolling of these rolls, obtaining membranes with different areas from about one square micron to one square millimeter and with a submicrometric thickness, corresponding to the wall thickness of the rolls.

The process described above was repeated with different energy values, in order to produce membranes having different thicknesses, considering that the defect profile that promotes the strain profile depends on the energy of the implanted ions.

The thickness value of the membranes was determined by two different characterization techniques.

The scanning electron microscopy technique was used to characterize the rolls obtained at the end of the implantation step, namely, to determine the thickness of their walls. The thickness of the enrolled membrane does not change with the thermal treatment to which the rolls are subjected. During the thermal treatment only the unrolling of the rolls occurs, resulting in membranes with the same thickness as the original roll walls.

The Rutherford backscattering spectrometry technique was also used, with which the value of the membrane thickness was measured after heat treatment.

Table 1 summarizes the average membrane thickness values for three implantations of Chromium with different energies (180 keV, 250 keV and 360 keV) performed at a fluence of $1x10^{15}$ ions/$cm^2$ and a flux of $2.083x10^{12}$ ions/$cm^2$.s.

Table 1: Thicknesses of membranes obtained with Chromium implantation.

| Ion | Flux (iões/$cm^2$.s) | Fluence (iões/$cm^2$) | Energy (keV) | Thickness (nm) |
|-----|----------------------|------------------------|--------------|----------------|
| $Cr^+$ | $2.083x10^{12}$ | $1x10^{15}$ | 180 | ~207 * |
| $Cr^{2+}$ | $2.083x10^{12}$ | $1x10^{15}$ | 250 | ~900 ** |
| $Cr^{2+}$ | $2.083x10^{12}$ | $1x10^{15}$ | 360 | ~1000 ** |

\* determined by scanning electron microscopy.
\*\* determined by Rutherford backscattering spectrometry.

**Example 2** - Production of roll and membrane of submicrometric thickness of $Ga_2O_3$ with implantation of Iron (Fe) ions

For the production of a membrane of submicrometric thickness of $Ga_2O_3$, a bulk monocrystal (with a thickness of several hundred micrometers) of $\beta$-$Ga_2O_3$ was used, having a surface plane (100) perpendicular to the [201] direction and implanted at room temperature, with a beam of $Fe^+$ ions with an energy of 180 keV, a flux of $1x10^{12}$ ions/$cm^2$. s and a fluence of $8\times10^{14}$ ions/$cm^2$ and with an angle of incidence normal to the surface. The formation of rolls on the surface of the monocrystalline $\beta$-$Ga_2O_3$ material was observed. Then, the previously formed rolls were transferred to a silicon substrate and annealed by a thermal annealing process with a holding time of 30 seconds at 700 °C and with a heating rate of 1 °C per second.

The process described above is repeated with different energy values, in order to produce membranes with different thicknesses, considering that the defect profile that promotes the strain profile depends on the energy of the implanted ions.

**Example 3** - Production of roll and membrane of submicrometric thickness of $Ga_3O_3$ with implantation of Nitrogen ions (N)

For the production of a membrane of submicrometric thickness of $Ga_2O_3$, a bulk monocrystal (with a thickness of several hundred microns) of $\beta$-$Ga_2O_3$ was used, having a surface plane (100) perpendicular to the [201] direction and implanted at room temperature, with an $N^+$ ion beam with an energy of 95 keV, a flux of $1x10^{12}$ ions/$cm^2$.s and a fluence of $6.3\times10^{15}$ ions/$cm^2$ and with an angle of incidence normal to the surface. The formation of rolls on the surface of the

monocrystalline β-Ga$_2$O$_3$ material was observed. Then, the previously formed rolls were transferred to a silicon substrate and annealed by a thermal annealing process with a holding time of 30 seconds at 700 °C and with a heating rate of 1 °C per second.

The process described above is repeated with different energy values, in order to produce membranes having different thicknesses, considering that the defect profile that promotes the strain profile depends on the energy of the implanted ions.

**Example 4** - Production of roll and membrane of submicrometric thickness of Ga$_3$O$_3$ with implantation of Carbon ions (C)

For the production of a membrane of submicrometric thickness of Ga$_2$O$_3$, a bulk monocrystal (with a thickness of several hundred micrometers) of β-Ga$_2$O$_3$ was used, having a surface plane (100) perpendicular to the [201] direction and implanted at room temperature, with a beam of C$^+$ ions with an energy of 65 keV, a flux of $1\times10^{12}$ ions/cm$^2$.s and a fluence of 7.5x10$^{15}$ ions/cm$^2$ and with an angle of incidence normal to the surface. The formation of rolls on the surface of the monocrystalline β-Ga$_2$O$_3$ material was observed. Then, the previously formed rolls were transferred to a silicon substrate and annealed by a thermal annealing process with a holding time of 30 seconds at 700 °C and with a heating rate of 1 °C per second.

The process described above is repeated with different energy values, in order to produce membranes having different thicknesses, considering that the defect profile that promotes the strain profile depends on the energy of the implanted ions.

**Example 5** - Production of roll and membrane of submicrometric thickness of Ga$_2$O$_3$ with implantation of tungsten ions (W)

For the production of a membrane of submicrometric thickness of Ga$_2$O$_3$, a bulk monocrystal (with a thickness of several hundred micrometers) of β-Ga$_2$O$_3$ was used, having a surface plane (100) perpendicular to the [201] direction and implanted at room temperature, with a beam of W$^{2+}$ ions with an energy of 350 keV, a flux of $1\times10^{12}$ ions/cm$^2$.s and a fluence of $2.8\times10^{14}$ ions/cm$^2$ and with an angle of incidence normal to the surface. The formation of rolls on the surface of the monocrystalline β-Ga$_2$O$_3$ material was observed. Then, the previously formed rolls were transferred to a silicon substrate and annealed by a a thermal annealing process with a holding time of 30 seconds at 700 °C and with a heating rate of 1 °C per second.

The process described above is repeated with different energy values, in order to produce membranes having different thicknesses, considering that the defect profile that promotes the strain profile depends on the energy of the implanted ions.

As verified by the previous examples, the process of the present invention is successfully performed using beams of different ions.

**Claims**

1. Process of production of roll and membrane of submicrometric thickness of Ga$_2$O$_3$ **characterized by** comprising the steps of:

    a) implanting ions in a semiconductor monocrystal of Ga$_2$O$_3$, with a cleavage plane parallel to the surface, at a temperature below 500 °C, making an ion beam strike along a non-parallel direction to the referred cleavage plane, with an energy in the range of 10-4000 keV, a flux in the range of $1\times10^{12}$-$1\times10^{14}$ ions/cm$^2$.s and a fluence in the range of $1\times10^{13}$-$1\times10^{16}$ ions/cm$^2$, with formation of at least one roll;
    b) subjecting the at least one roll formed in step a) to a thermal treatment at a temperature equal to or higher than 500°C.

2. Process according to claim 1 **characterized by** repeating the steps a) and b) in order.

3. Process according to claims 1 and 2 **characterized in that** it has an additional intermediate step between steps a) and b), wherein the, at least one, formed roll is transferred to a substrate stable at the temperature of the thermal treatment of step b).

4. Process according to claim 3 **characterized in that** the substrate is silicon.

5. Process according to any of the claims 1 to 4 **characterized in that** it comprises a step prior to step a), wherein at least one additional conductive, semiconducting or insulating layer is deposited on the surface of the monocrystal

of $Ga_2O_3$.

6. Process according to any of the claims 1 to 5 **characterized in that** the ion beam is selected from the group of ions comprising Chromium (Cr), Iron (Fe), Nitrogen (N), Carbon (C) and Tungsten (W) ions.

7. Process according to any of the claims 1 to 6 **characterized in that** the thermal treatment of step b) is performed at an annealing temperature of 700°C for 30 seconds and with a heating rate of 1 °C per second.

8. Process according to any of the claims 1 to 7 **characterized in that** the ion beam implantation is performed in stationary mode.

9. Process according to any of the claims 1 to 7 **characterized in that** the ion beam implantation is performed in sweeping mode.

**Patentansprüche**

1. Verfahren zur Herstellung einer Rolle und einer Membran mit einer Dicke unter einem Mikrometer aus $Ga_2O_3$, **dadurch gekennzeichnet, dass** es die folgenden Schritte umfasst:

a) Auftragen von Ionen in einen Halbleiter-Einkristall aus $Ga_2O_3$ mit einer Spaltebene parallel zur Oberfläche, bei einer Temperatur unter 500 °C, wobei ein Ionenstrahl in einer nicht parallelen Richtung zur genannten Spaltebene auftrifft, mit einer Energie im Bereich von 10-4000 keV, einem Fluss im Bereich von $1 \times 10^{12}$-$1 \times 10^{14}$ Ionen/cm$^2$.s und einer Fluenz im Bereich von $1 \times 10^{13}$-$1 \times 10^{16}$ Ionen/cm$^2$, unter Bildung von mindestens einer Rolle;
b) Unterziehen der mindestens einen in Schritt a) gebildeten Rolle einer Wärmebehandlung, bei einer Temperatur von gleich oder höher als 500 °C.

2. Verfahren nach Anspruch 1, **gekennzeichnet durch** die Wiederholung der Schritte a) und b) in der angegebenen Reihenfolge.

3. Verfahren nach den Ansprüchen 1 und 2, **dadurch gekennzeichnet, dass** es einen zusätzlichen Zwischenschritt zwischen den Schritten a) und b) umfasst, bei dem die mindestens eine geformte Rolle auf eine Trägerschicht übertragen wird, die bei der Temperatur der Wärmebehandlung von Schritt b) beständig ist.

4. Verfahren nach Anspruch 3, **dadurch gekennzeichnet, dass** die Trägerschicht Silizium ist.

5. Verfahren nach einem der Ansprüche 1 bis 4, **dadurch gekennzeichnet, dass** es einen Schritt vor Schritt a) umfasst, bei dem mindestens eine zusätzliche leitende, halbleitende oder isolierende Schicht auf der Oberfläche des Einkristalls aus $Ga_2O_3$ abgeschieden wird.

6. Verfahren nach einem der Ansprüche 1 bis 5, **dadurch gekennzeichnet, dass** der Ionenstrahl aus der Gruppe von Ionen, die Chrom- (Cr), Eisen- (Fe), Stickstoff- (N), Kohlenstoff- (C) und Wolfram- (W) Ionen umfasst, ausgewählt wird.

7. Verfahren nach einem der Ansprüche 1 bis 6, **dadurch gekennzeichnet, dass** die Wärmebehandlung in Schritt b) bei einer Glühtemperatur von 700 °C für 30 Sekunden und mit einer Heizrate von 1 °C pro Sekunde durchgeführt wird.

8. Verfahren nach einem der Ansprüche 1 bis 7, **dadurch gekennzeichnet, dass** das Ionenstrahlauftragen in der stationären Wirkungsweise durchgeführt wird.

9. Verfahren nach einem der Ansprüche 1 bis 7, **dadurch gekennzeichnet, dass** das Ionenstrahlauftragen in der Abtast-Wirkungsweise durchgeführt wird.

**Revendications**

1. Procédé de production d'un rouleau et d'une membrane d'épaisseur inférieure à un micromètre de $Ga_2O_3$, **carac-**

**térisé en ce qu'**il comprend les étapes de:

a) implanter des ions dans un monocristal semi-conducteur de $Ga_2O_3$, avec un plan de clivage parallèle à la surface, a une température inférieure à 500 °C, en faisant frapper un faisceau d'ions dans une direction non parallèle audit plan de clivage, avec une énergie dans la plage de 10-4000 keV, un flux dans la plage de $1 \times 10^{12}$-$1 \times 10^{14}$ ions/cm$^2$.s et une fluence dans la plage de $1 \times 10^{13}$-$1 \times 10^{16}$ ions/cm$^2$, avec formation d'au moins un rouleau;
b) soumettre le au moins un rouleau formé à l'étape a) à un traitement thermique a une température égale ou supérieure à 500 °C.

2. Procédé selon la revendication 1, **caractérisé par** la répétition des étapes a) et b) par l'ordre indiquée.

3. Procédé selon les revendications 1 et 2, **caractérisé en ce qu'**il comporte une étape intermédiaire additionnel entre les étapes a) et b), dans laquelle le au moins un rouleau formé est transféré sur un substrat stable à la température du traitement thermique de l'étape b).

4. Procédé selon la revendication 3, **caractérisé en ce que** le substrat est du silicium.

5. Procédé selon l'une quelconque des revendications 1 à 4, **caractérisé en ce qu'**il comprend une étape préalable à l'étape a), dans laquelle au moins une couche conductrice, semi-conductrice ou isolante supplémentaire est déposée à la surface du monocristal de $Ga_2O_3$.

6. Procédé selon l'une quelconque des revendications 1 à 5, **caractérisé en ce que** le faisceau d'ions est choisi dans le groupe d'ions comprenant ions Chrome (Cr), Fer (Fe), Nitrogène (N), Carbone (C) et Tungstène (W).

7. Procédé selon l'une quelconque des revendications 1 à 6, **caractérisé en ce que** le traitement thermique de l'étape b) est réalisé à une température de recuit de 700 °C pendant 30 secondes et avec une vitesse de chauffage de 1 °C par seconde.

8. Procédé selon l'une quelconque des revendications 1 à 7, **caractérisé en ce que** l'implantation du faisceau ionique est réalisée en mode stationnaire.

9. Procédé selon l'une quelconque des revendications 1 à 7, **caractérisé en ce que** l'implantation du faisceau ionique est réalisée en mode balayage.

Figure 1

Figure 2

Figure 3

Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6008126 A
- US 5882987 A

- US 8313966 B2

### Non-patent literature cited in the description

- **MIKAYLA A. YODER et al.** *J. Am. Chem. Soc.,* 2018, vol. 140, 9001-9019
- **MINGHUANG HUANG et al.** *Nanoscale,* 2011, vol. 3, 96
- **M. BRUEL ; B. ASPAR ; A.-J. AUBERTON-HERVÉ.** *Jpn. J. Appl. Phys.,* 1997, vol. 36, 1636
- **C. QIAN ; B. TERREAULT.** *J. Appl. Phys.,* 2001, vol. 90, 5152
- **C. MICLAUS ; G. MALOUF ; SM JOHNSON ; MS GOORSKY.** *J. Electron. Mat.,* 2005, vol. 34 (6), 859

- **S. HAYASHI ; D. BRUNO ; MS GOORSKY.** *Appl. Phys. Lett.,* 2004, vol. 85, 236
- **C. MICLAUS ; MS GOORSKY.** *J. Phys. D: Appl. Phys.,* 2003, vol. 36, A177
- **MICHAEL E. LIAO et al.** *ECS J. Solid State Sci. Technol.,* 2019, vol. 8, 673
- **SCHMIDT et al.** *Physica E,* 2002, vol. 13, 969
- Wafer-scale Heterogeneous Integration of Monocrystalline beta-Ga2O3 Thin Films on SiC for Thermal Management by Ion-Cutting Technique. **ZHE CHENG et al.** ARXIV.ORG. CORNELL UNIVERSITY LIBRARY, 27 May 2020, vol. 201